Europäisches Patentamt

European Patent Office

Office européen des brevets

(11) Publication number: **0 084 260**
**B1**

## EUROPEAN PATENT SPECIFICATION

(45) Date of publication of patent specification: **02.04.86**

(51) Int. Cl.⁴: **G 01 R 31/28**

(21) Application number: **82306939.8**

(22) Date of filing: **23.12.82**

(54) Semiconductor integrated-circuit device with test circuit.

(30) Priority: **29.12.81 JP 214815/81**

(43) Date of publication of application:
**27.07.83 Bulletin 83/30**

(45) Publication of the grant of the patent:
**02.04.86 Bulletin 86/14**

(84) Designated Contracting States:
**DE FR GB**

(56) References cited:
**FR-A-2 448 723**
**FR-A-2 448 724**
**FR-A-2 455 287**
**GB-A-2 042 741**

(73) Proprietor: **FUJITSU LIMITED**
**1015, Kamikodanaka Nakahara-ku**
**Kawasaki-shi Kanagawa 211 (JP)**

(72) Inventor: **Kabashima, Katsuhiko**
**Fujitsu Miyauchi-ryo 407-1, Miyauchi**
**Nakahara-ku Kawasaki-shi Kanagawa 211 (JP)**
Inventor: **Takemae, Yoshihiro**
**20-5-9-301, Utsukushigaoka 1-chome**
**Midori-ku Yokohama-shi Kanagawa 227 (JP)**
Inventor: **Nozaki, Shigeki**
**Mezon Hisasue 203 473, Hisasue**
**Takatsu-ku Kawasaki-shi Kanagawa 213 (JP)**
Inventor: **Ohira, Tsuyoshi**
**Kurasi-no-kyoshitsu 102 125, Mizonokuchi**
**Takatsu-ku Kawasaki-shi Kanagawa 213 (JP)**
Inventor: **Miyahara, Hatsuo**
**Dai-3 Fujigaoka-ryo 1-2, Fujigaoka 2-chome**
**Midori-ku Yokohama-shi Kanagawa 227 (JP)**
Inventor: **Kanai, Masakazu**
**Dai-1 Fujigaoka-ryo, 318 23-10, Umegaoka**
**Midori-ku Yokohama-shi Kanagawa 227 (JP)**
Inventor: **Enomoto, Seiji**
**3-16-403, Susukino-danchi**
**Midori-ku Yokohama-shi Kanagawa 227 (JP)**

Courier Press, Leamington Spa, England.

**0 084 260**

⁷⁴ Representative: **Fane, Christopher Robin King et al**
**HASELTINE LAKE & CO. Hazlitt House**
**28 Southampton Buildings Chancery Lane**
**London, WC2A 1AT (GB)**

## Description

The present invention relates to a semiconductor integrated circuit (IC) device including test circuitry.

IC's are usually mass produced from the viewpoint of reduction of unit costs and standardization of capabilities. Such economic considerations, etc., make it advantageous to mass produce IC's having a main-semiconductor circuit and a sub-semiconductor circuit as an option at one time. The mass produced optional semiconductor circuits of each IC chip are then selectively made active by prepackaging wire bonding in accordance with individual user needs.

For example, a dynamic metal insulated semiconductor (MIS) memory circuit is generally used together with a so-called refresh counter. The aforesaid main-semiconductor circuit may be used for the dynamic MIS memory circuit, and the aforesaid sub-semiconductor circuit may be used for the refresh counter. Many users, however, may not need the latter circuit. In such cases, the sub-semiconductor circuit is offered as an option. If a user does not need the optional circuit, wire bonding is not effected in the IC manufacturing process.

After packaging, the IC products are usually tested to confirm whether they contain both active main- and sub-semiconductor circuits or only active main-semiconductor circuits. The IC packages are then labelled according to the results of the tests.

In a confirmation test of the prior art, a predetermined test signal is externally supplied to the IC package under testing to cause the IC to perform an operation based on the signal. If the results of the test confirm the operation of a first function, it is concluded that the IC product has only an active main-semiconductor circuit. Contrary to this, if they confirm the operation of a second function, it is concluded that the IC product has both active main- and sub-semiconductor circuits.

In the prior art, however, whether the IC product includes only a main-semiconductor circuit or both a main-semiconductor circuit and an active sub-semiconductor circuit depend on whether the sub-semiconductor circuit is commonly connected to a pin leading to an external power source. In activating the sub-semiconductor circuit, it is also necessary to connect its input ports to the specified pins of the IC package.

Therefore, in the prior art test, if it is desired to confirm the operation of the second function in the IC, but only the first function operated, there is no way to determine whether both or only one of the wire bondings for connection with the external power source and the input ports are faulty. This is inconvenient in view of IC production management.

It is accordingly desirable to provide such a semiconductor IC device which can correctly discriminate at least whether a power source port of the sub-semiconductor circuit is wire bonded with a pin for the external power source.

According to the present invention, there is provided a single-chip semiconductor integrated circuit device in which the semiconductor chip incorporates test circuitry comprising an MIS transistor and an MIS diode connected in series with one another and connected to one of a plurality of external input/output pins of normal working circuitry incorporated in the chip, characterised in that the said MIS transistor has its drain connected to ground level wiring of the device, and the MIS diode is connected between the source of the transistor and the said one external pin so as to be reverse biased when the potential of that pin is within the range of voltages which occur thereat during normal use of the device (other than during testing); whereby when a normal supply voltage is applied to the said normal working circuitry a test current can be caused to pass through the said one pin by the application thereto of a first test voltage if a circuitry node which is connected to a gate of the said transistor is at one of two possible voltages, which voltages are respectively equal to the said supply voltage and the ground level voltage of the circuitry, whereas the application of a second test voltage, larger in magnitude than the said first test voltage, is needed to cause such a current to pass through the said one pin if the said circuitry node is at the other of the said two possible voltages.

An embodiment of the present invention as stated above can provide a semiconductor IC device including a general-purpose test circuit enabling detection of the level at a particular internal node of the IC chip, from outside of the IC package, via a particular external pin thereof.

It is to be noted, incidentally, that test circuitry which employs an MIS transistor in series with an MIS diode, to perform a different kind of test, is known per se from GB 2042741.

Reference will now be made, by way of example, to the accompanying drawings, wherein:

Fig. 1 shows a plan view schematically illustrating a semiconductor IC not yet packaged;

Fig. 2 is a circuit diagram of a semiconductor device according to an embodiment of the present invention;

Fig. 3A is an equivalent circuit diagram of part of the circuitry of Fig. 1 when in one mode of operation; and

Fig. 3B is an equivalent circuit diagram of the said part of the circuitry when in a different mode of operation.

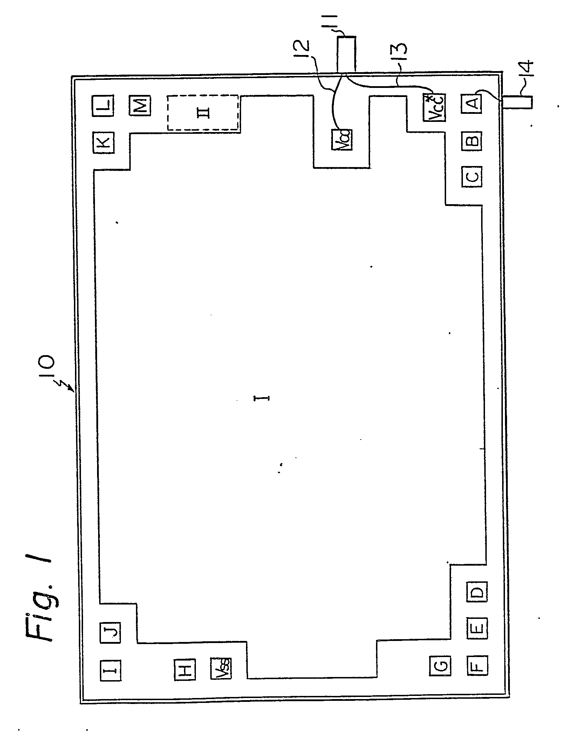

In Fig. 1, reference numeral 10 represents a chip. In and on the chip 10, a first semiconductor IC I (corresponding to a main-semiconductor circuit) and a second semiconductor IC II (corresponding to a sub-semiconductor circuit) are fabricated. Many pads A through M, $V_{cc}$, $V_{cc}$*, and $V_{ss}$, used for the power supply, communication of input/output (I/O) signals, and so on, are distributed thereon. Wire bonding is performed between these pads and corresponding external pins. Usually, there are 16 pins. In Fig. 1, however, not all of the pins and wire bondings are illustrated.

Of these members, the pads $V_{cc}$ and $V_{cc}*$ are particularly relevant to the illustrated embodiment of the present invention. In association with ground level pad $V_{ss}$, pads $V_{cc}$ and $V_{cc}*$ serve respectively for the application of normal power supply voltage to drive the first and second semiconductor IC's I and II. In this case, the pads $V_{cc}$ and $V_{cc}*$ are commonly connected, through wire bondings 12 and 13, respectively, to a single pin 11 connected to an external power source (not shown). Such common pin occupation is preferable in view of economical use of the fixed number of pins. The wire bonding 12 is always provided. The wire bonding 13 is provided in accordance with individual user needs, as previously mentioned.

Incidentally it should be understood that, in Fig. 1, illustration of wiring between the pad $V_{cc}$ and the first semiconductor IC I and also wiring between the pad $V_{cc}*$ is omitted for brevity.

Below, it will be explained how an embodiment of the present invention enables external detection of such wire bonding after the semiconductor chip is packaged.

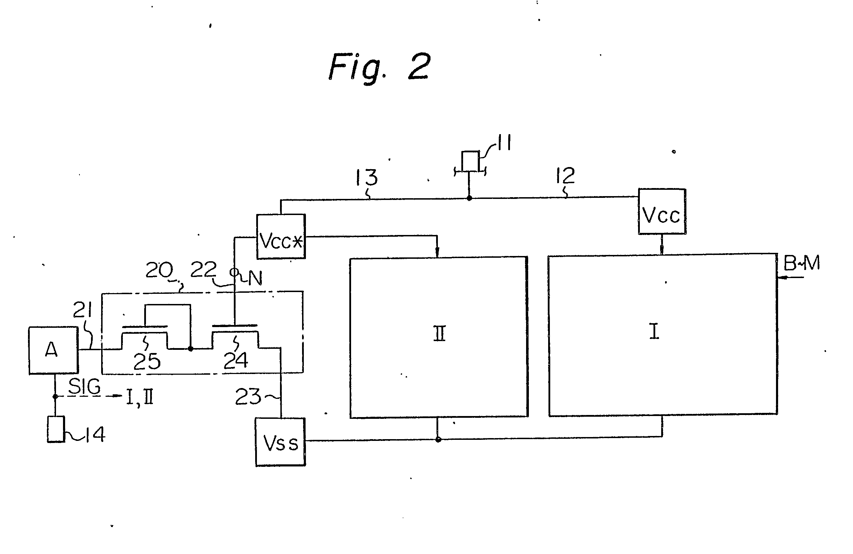

Figure 2 is a circuit diagram of a semiconductor circuit having test circuitry according to an embodiment of the present invention. In Fig. 2, parts the same as Fig. 1 are represented by the same reference numerals or characters, and a block 20 indicated by chain-dotted lines represents the test circuitry. The test circuitry 20 is connected to the pad A, the pad $V_{cc}*$, and the pad $V_{ss}$ via additional lines 21, 22, and 23, respectively. The pad A is just an example; any other pad may be used instead. The pad A is connected to an external I/O pin 14.

The test circuitry 20 is comprised of a series-connected MIS transistor 24 and MIS diode 25. The gate of the MIS transistor 24 is connected to the line 22. It should be noted that in the illustrated embodiment of the present invention, the test circuitry 20 functions to detect the existence of the wire bonding 13. From the viewpoint of the general purpose application of the present invention, however, the test circuitry 20 functions to detect the level at an internal node N under testing, in which either one of the ground level voltage ($V_{ss}$) or the power supply voltage ($V_{cc}$) occurs at the pad $V_{cc}*$ (or at the internal node N to be tested).

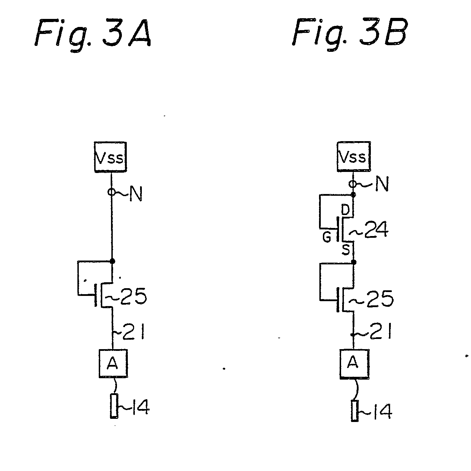

Figure 3A is an equivalent circuit diagram of the test circuit created under a mode where the second semiconductor IC II is active. Figure 3B is an equivalent circuit diagram of the test circuit created under a mode where the second semiconductor IC II is not active. As previously mentioned, according to the illustrated embodiment of the present invention, the existence of the wire bonding 13 shown in Fig. 1 is detected by way of an external I/O pin. Similarly, from a general purpose point of view, whichever of the power supply and ground level voltages occurs at the particular internal node N is detected by way of the external I/O pin.

When the wire bonding 13 exists in the chip, the pad $V_{cc}*$ is activated, thereby turning on the MIS transistor 24 via the line 22. Similarly, when the node N is activated at the power source level, the MIS transistor 24 is turned on. Such a mode corresponds to the equivalent circuit diagram of the test circuitry shown in Fig. 3A.

On the other hand, when the wire bonding 13 does not exist in the chip, the pad $V_{cc}*$ is not activated. At this time, since the pad $V_{cc}*$ is also connected, via a resistor having high resistance (not shown) to ground level wiring of the device, the pad $V_{cc}*$ is set at the ground level. Thus the level of the power supply pad for the second semiconductor IC II is set at the ground level. Accordingly, the ground level is applied to the gate of the MIS transistor 24. Similarly, when the node N is set at the ground level, that ground level is applied to the gate of the MIS transistor 24. Such a mode corresponds to the equivalent circuit diagram of the test circuitry shown in Fig. 3B.

That is, the MIS transistor 24 substantially forms a conductive path if the internal node N is at the power supply voltage level and substantially forms a transistor in which the gate (G) and drain (D) thereof are electrically shorted if the internal node N is at the ground level. The symbol S denotes a source of the MIS transistor 24.

Thus, the existence or otherwise of the wire bonding 13, similarly whether the power supply voltage or the ground level exists at the internal node N, can be determined by investigating whether the equivalent circuit diagram of Fig. 3A or Fig. 3B exists. The circuit modes of Fig. 3A and Fig. 3B can be distinguished by observation from the pad A. In practice, such observation is achieved via the external I/O pin 14 connected to the pad A inside of the chip. It should be noted that the pin 14 works as a test pin during a test mode, but as an I/O signal pin during a normal operation mode.

In carrying out the test mode, a test circuit is drawn from the external I/O pin 14. Under the circuit mode of Fig. 3A, i.e. with the wire bonding 13 or with application of the power supply voltage to the internal node N, to draw such a current requires application of a first negative voltage, larger in magnitude than the threshold voltage $V_{th}$ of the MIS diode 25, to the pin 14. Thus, if a voltage of $-V_{th}$ is applied to the pin 14, and a current flows through the pin 14, one may conclude that the circuit mode of Fig. 3A is created in the chip.

Contrary to the above, under the circuit mode of Fig. 3B, i.e. with no wire bonding 13 or with application of the ground level to the internal node N, to draw such a current requires application of a second negative voltage, larger in magnitude than the sum of the threshold voltage $V_{th}$ of each of the MIS diode 25 and MIS transistor 24, to the pin 14. Thus, if a voltage of $-2V_{th}$ is applied to the pin 14, and a current flows through the pin 14, one may conclude that the circuit mode of Fig. 3B is created in the chip.

Thus, the existence of the wire bonding 13, similarly the power supply voltage or the ground level at the internal node N, can be easily distinguished by the voltage ($-V_{th}$ or $-2V_{th}$) applied to the pin 14. The MIS diode 25 functions as a diode for preventing a flow of a reverse current to the test circuit 20 during a normal operation mode. That is, the MIS diode 25 is set to a reverse biased state when the potential of the pin 14 is within the range of voltages which occur thereat during normal use of the device (other than during testing), i.e. during application of normal (non-test) I/O signals SIG as indicated by a broken line arrow in Fig. 2 from the pin 14.

As explained above, whether the power supply voltage or the ground level occurs at the internal node N in the semiconductor IC chip can be correctly externally distinguished via the external I/O pin 14.

## Claims

1. A single-chip semiconductor integrated circuit device in which the semiconductor chip incorporates test circuitry comprising an MIS transistor (24) and an MIS diode (25) connected in series with one another and connected to one (14) of a plurality of external input/output pins of normal working circuitry (I, II) incorporated in the chip, characterised in that the said MIS transistor (24) has its drain connected to ground level wiring ($V_{ss}$) of the device, and the MIS diode (25) is connected between the source of the transistor (24) and the said one external pin (14) so as to be reverse biased when the potential of that pin (14) is within the range of voltages which occur thereat during normal use of the device (other than during testing); whereby when a normal supply voltage is applied to the said normal working circuitry a test current can be caused to pass through the said one pin (14) by the application thereto of a first test voltage if a circuitry node (N) which is connected to a gate of the said transistor (24) is at one of two possible voltages, which voltages are respectively equal to the said supply voltage and the ground level voltage of the circuitry, whereas the application of a second test voltage, larger in magnitude than the said first test voltage, is needed to cause such a current to pass through the said one pin if the said circuitry node (N) is at the other of the said two possible voltages.

2. A device as claimed in claim 1, wherein the said one of the two possible voltages is the said supply voltage, and the said first test voltage is substantially equal to $-V_{th}$, where $V_{th}$ is the magnitude of the threshold voltage of the said transistor (24) and also the magnitude of the threshold voltage of the said diode (25), the said second test voltage being substantially equal to $-2v_{th}$.

3. A device as claimed in claim 1 or 2, wherein the said MIS diode (25) and the said one pin (14) are wired together by way of a pad mounted on the semiconductor chip.

## Revendications

1. Dispositif à circuit intégré semiconducteur à une seule puce, dans lequel la puce semiconductrice contient une circuiterie d'essai comprenant un transistor MIS (24) et une diode MIS (25) connectés en série l'un avec l'autre et connectés à une broche (14) prise parmi plusieurs broches d'entrée-sortie externes du circuit normal de travail (I, II) existant dans la puce, caractérisé en ce que ledit transistor MIS (24) est connecté par son drain au câblage ($V_{ss}$) de connexion au potentiel de la terre du dispositif, et la diode MIS (25) est connectée entre la source du transistor (24) et ladite broche externe (14) de façon à être polarisée en sens non passant lorsque le potentiel de cette broche (14) se trouve à l'intérieur de la gamme des tensions qui se produisent à cet endroit pendant l'utilisation normale du dispositif (qui sont autres que pendant l'essai), si bien que, lorsqu'une tension d'alimentation normale est appliquée audit circuit normal de travail, un courant d'essai peut être amené à passer dans ladite broche (14) par application à celle-ci d'une première tension d'essai si un noeud de circuit (N) qui est connecté à une grille dudit transistor (24) se trouve à l'une de deux tensions possibles, lesquelles tensions sont respectivement égales à ladite tension d'alimentation et à la tension du potentiel de terre du circuit, tandis que l'application d'une deuxième tension d'essai, plus grande que la première tension d'essai, est nécessaire pour faire qu'un courant passe par ladite broche si ledit noeud de circuit (N) se trouve à l'autre desdites deux tensions possibles.

2. Dispositif selon la revendication 1, où ladite première des deux tensions possibles est ladite tension d'alimentation, et ladite première tension d'essai est sensiblement égale à $-V_{th}$, où $V_{th}$ est l'amplitude de la tension de seuil dudit transistor (24) et est également l'amplitude de la tension de seuil de ladite diode (25), ladite deuxième tension d'essai étant sensiblement égale à $-2V_{th}$.

3. Dispositif selon la revendication 1 ou 2, où ladite diode MIS (25) et ladite broche (14) sont câblées ensemble par l'intermédiaire d'un plot monté sur la puce semiconductrice.

## Patentansprüche

1. Integrierte Ein-Chip-Halbleiterschaltungsvorrichtung, bei welcher das Halbleiterchip eine Prüfschaltung enthält, die einen MIS-Transistor (24) und ein MIS-Diode (25) umfaßt, die in Reihe miteinander verbunden sind und mit einem (14) von einer Anzahl von externen Eingangs-Ausgangs-Stiften einer normal arbeitenden Schaltung (I, II), die in dem Chip enthalten ist, verbunden sind, dadurch gekennzeichnet, daß das Drain des genannten MIS-Transistors (24) mit einer Erdpegelverdrahtung ($V_{ss}$) der Vorrichtung verbunden ist und die MIS-Diode (25) zwischen der Source des Transistors (24) und dem genannten einen externen Stift (14) so angeschlossen ist, daß sie in Sperrichtung vorgespannt ist, wenn das Potential des Stiftes (14) sich innerhalb des Bereiches von Spannungen befindet, welche an diesem während der normalen Verwendung der Vorrichtung (einer von dem Prüfen verschiedenen) befindet; wodurch dann, wenn eine normale Versorgungsspannung der normal arbeitenden Schaltung zugeführt wird, ein Prüfstrom veranlaßt werden kann, durch Anlegen einer ersten Prüfspannung an den genannten einen Stift (14) durch diesen hindurchzufließen, wenn ein Schaltungsknotenpunkt (N), der mit einem Gate des genannten Transistors (24) verbunden ist, sich auf einer von zwei möglichen Spannungen befindet, die jeweils gleich der genannten Versorgungsspannung bzw. der Erdpegelspannung der Schaltung ist, wohingegen die Anwendung einer zweiten Prüfspannung, die höher als die genannte erste Prüfspannung ist, erforderlich ist, um einen solchen Strom durch den genannten einen Stift hindurchfließen zu lassen, falls der genannte Schaltungsknotenpunkt (N) sich auf der anderen der genannten beiden möglichen Spannungen befindet.

2. Vorrichtung nach Anspruch 1, bei welcher die genannte eine der beiden möglichen Spannungen die genannte Versorgungsspannung ist, und die genannte erste Prüfspannung im wesentlichen gleich $-V_{th}$ ist, wobei $V_{th}$ die Größe der Schwellwertspannung des genannten Transistors (24) und auch die Größe der Schwellwertspannung der genannten Diode (25) ist, und die genannte zweite Prüfspannung im wesentlichen gleich $-2V_{th}$ ist.

3. Vorrichtung nach Anspruch 1 oder 2, bei welcher die genannte MIS-Diode (25) und der genannte eine Stift (14) miteinander mittels eines Pad verdrahtet sind, welches auf dem Halbleiterchip angeordnet ist.

Fig. 1

10

I  J                                K  L
                                        M

H

Vss                                   II

              I

                              Vdd        12
                                           11

                                        13

                                     Vcc

G
F  E  D                        C  B  A
                                        14

0 084 260

Fig. 2

0 084 260

# Fig. 3A

# Fig. 3B